# FASCICULE DE BREVET EUROPEEN

(11) **EP 2 212 262 B1**
(45) Date de publication et mention de la délivrance du brevet: **09.04.2014**
(21) Numéro de dépôt: 08857820.8
(22) Date de dépôt: 20.11.2008
(51) Int. Cl.: C04B 35/536, F24J 2/48, F28F 21/02, H01M 2/16, H01M 8/10, C04B 35/52, H01L 23/373, C04B 35/626, F28F 13/00, H01L 21/48

(54) **PROCEDE DE FABRICATION D'UN SOLIDE CONDUCTEUR THERMIQUE ET/OU ELECTRIQUE**
VERFAHREN ZUR HERSTELLUNG EINES WÄRME- UND/ODER STROMLEITENDEN FESTSTOFFS
PROCESS FOR MANUFACTURING A THERMALLY AND/OR ELECTRICALLY CONDUCTING SOLID

(30) Priorité: 22.11.2007 FR 0708192
(43) Date de publication de la demande: 04.08.2010
(73) Titulaire: Université Paul Sabatier de Toulouse III, 31062 Toulouse Cedex 9 (FR); Institut National Polytechnique De Toulouse, 31029 Toulouse Cedex 4 (FR); Centre National de la Recherche Scientifique (CNRS), 75016 Paris (FR)
(72) Inventeur: GROS, Pierre, F-31770 Colomiers (FR); PROSDOCIMI, Jacques, F-31170 Tournefeuille (FR)
(74) Mandataire: Cabinet BARRE LAFORGUE & associés
(86) Numéro de dépôt international: PCT/FR2008/052093
(87) Numéro de publication internationale: WO 2009/071807

(56) Documents cités:
- JP-A- 2 280 944
- US-A- 3 325 340
- US-A1- 2004 164 438

## Description

L'invention concerne un procédé de fabrication d'un solide conducteur thermique et/ou électrique.

L'invention s'applique en particulier à la réalisation de réacteurs chimiques, d'interfaces d'échange thermique, de revêtements sélectifs optiques, d'électrodes, de revêtements conducteurs de l'électricité..., mais aussi d'objets moulés de toutes sortes, ayant des propriétés de conduction thermique et/ou électrique.

Dans toutes ses versions et dans toutes ses applications, l'invention vise à fournir un procédé de fabrication extrêmement simple, peu coûteux et qui conduise à l'obtention d'un solide possédant des propriétés satisfaisantes en terme de conduction thermique et/ou électrique. Un objectif de l'invention est aussi de fournir un procédé de fabrication permettant de contrôler les conductivités thermique et électrique obtenues.

On connaît des procédés de fabrication d'objets ou de produits utilisant du graphite expansible ou expansé. Le graphite expansible est un graphite traité à l'aide d'une solution d'intercalation, qui s'insère entre les feuillets de carbone du graphite. Le graphite expansé est obtenu par exfoliation d'un graphite expansible : sous l'effet d'un choc thermique, la solution d'intercalation du graphite expansible se sublime, écartant les feuillets de carbone du graphite.

Parmi les procédés utilisant du graphite expansible, on distingue :
- les procédés dans lesquels le graphite est conservé sous sa forme expansible. Ces procédés sont exclusivement mis en oeuvre pour fabriquer des objets ou produits intumescents, ce qui n'est pas l'objectif de l'invention. Lorsque ces objets ou produits sont exposés au feu, le graphite expansible qu'ils contiennent s'exfolie, formant une couche thermiquement isolante et étanche aux fumées.
- les procédés au cours desquels le graphite expansible est transformé en graphite expansé, par exfoliation au sein d'un moule. Ces procédés sont mis en oeuvre pour fabriquer des objets moulés. US 5 288 429 décrit un procédé dans lequel : on mélange du graphite expansible avec un liquide de façon à obtenir un mélange humide ; puis l'on introduit ce mélange humide dans un moule que l'on chauffe à une température supérieure à 180°C (et de préférence de l'ordre de 600°C). Le mélange humide peut également contenir de la vermiculite à titre d'additif. En s'exfoliant, le graphite remplit le moule (son volume peut être multiplié par 800) et se structure par compression contre les parois du moule. Les objets moulés ainsi obtenus présentent un faible poids, une grande résistance à la chaleur et au feu, une bonne stabilité mécanique, une conductivité électrique correcte, des propriétés de blindage électromagnétique. Mais le procédé décrit par US 5 288 429 présente les inconvénients suivants : il suppose l'utilisation d'un moule d'usine, spécifiquement fabriqué pour l'objet aux dimensions et formes souhaitées ; de surcroît, ce moule doit être apte à supporter l'étape de chauffage à température élevée nécessaire à l'exfoliation du graphite en son sein. Ces contraintes grèvent considérablement le coût de revient des objets moulés selon US 5 288 429.

Un objectif de l'invention est de proposer un procédé de fabrication d'objets moulés qui soit extrêmement simple et peu coûteux. Un autre objectif de l'invention est d'offrir la possibilité de réaliser un objet moulé *"in situ",* c'est-à-dire directement moulé dans le dispositif destiné finalement à le recevoir, sans avoir à fabriquer préalablement l'objet à l'aide d'un moule d'usine.

Parmi les procédés utilisant du graphite expansé, on distingue :
- les procédés dans lesquels le graphite expansé est associé à un liant organique polymérique tel qu'une résine phénolique, époxyde, cellulosique ou encore styrénique, dont le durcissement nécessite une étape de cuisson. Non seulement ces procédés présentent les inconvénients précités (nécessaire utilisation d'un moule d'usine, étape de cuisson...) et utilisent des produits toxiques et/ou non recyclables, mais aussi et surtout, ils conduisent généralement à l'obtention d'objets isolants thermiques et électriques. A cet égard, US 6 384 094 préconise d'ajouter du graphite expansé à une suspension de polymères de styrène expansibles en cours de polymérisation, en vue de diminuer la conductivité thermique du polystyrène obtenu ;
- les procédés dans lesquels le graphite expansé est consolidé par compression, tel que le procédé décrit par FR 2 715 082, commenté ci-après. Parce qu'ils comprennent des étapes de compression, ces procédés ne permettent pas de réaliser des objets *"in situ".* La réalisation d'objets de forme complexe est techniquement impossible ou financièrement peu rentable (des empreintes devant être fabriquées spécifiquement pour chaque forme) ;
- les procédés combinant les deux techniques précédentes (utilisation d'un liant organique et compression). Ces procédés cumulent les inconvénients des deux techniques.

Comme précédemment indiqué, l'invention s'applique notamment à la réalisation de réacteurs chimiques, et en particulier à la réalisation d'un bloc composite pour pompe à chaleur chimique. FR 2 715 082 susmentionné décrit un procédé de réalisation d'un bloc composite actif poreux pour pompe à chaleur chimique, constitué d'un support et d'un agent actif. Selon ce procédé connu, on mélange du graphite expansé et un composé lamellaire exfolié tel la vermiculite ; on comprime le mélange afin de former un support solide poreux ayant une densité en graphite comprise entre 0,03 et 0,5 ; on imprègne le support d'agent actif. Le bloc composite ainsi obtenu est ensuite soit introduit à l'intérieur d'un circuit échangeur de chaleur, soit placé à l'intérieur d'une enceinte et percé de canaux destinés à accueillir des tubes échangeurs véhiculant un fluide calorifique. Lorsque la pompe à chaleur est en fonctionnement, le bloc composite est traversé par un gaz qui réagit avec l'agent actif (qui peut être un sel) ou est adsorbé par ce dernier (l'agent actif est dans ce cas une zéolithe par exemple). La réaction chimique ou l'adsorption physique est exothermique, et la chaleur dégagée est conduite par le graphite expansé comprimé présent dans le support. Parce qu'il comprend une étape de compression, le procédé décrit par FR 2 715 082 ne permet pas de réaliser un bloc composite actif *"in situ",* c'est-à-dire directement à l'intérieur d'un élément de pompe à chaleur par exemple. Le bloc actif doit être- préalablement fabriqué, aux formes et dimensions de l'élément destiné à le recevoir, puis introduit dans cet élément. En outre, seule une faible quantité d'agent actif peut être absorbée dans le bloc composite (du fait de la compression, le bloc est relativement dense), et la quantité d'agent actif réellement absorbée est difficilement contrôlable.

Un objectif de l'invention est de proposer un procédé de fabrication d'un réacteur chimique qui soit extrêmement simple, puisse être mis en oeuvre *"in situ"* et conduise à l'obtention d'un réacteur pouvant intégrer une quantité d'agent actif contrôlée avec précision et si nécessaire importante.

L'invention s'applique également à la réalisation d'une interface d'échange thermique entre un élément émetteur de chaleur et un élément de récupération et/ou d'évacuation de cette chaleur, dans un échangeur thermique ou encore dans un circuit électronique. Les interfaces d'échange thermique connues, utilisées dans les circuits électroniques notamment pour évacuer vers un élément radiateur la chaleur dissipée par un microprocesseur ou par un composant électronique de puissance, sont généralement réalisées à partir de pâtes thermiques comprenant des particules d'argent dispersées dans une matrice en silicone. Ces interfaces offrent une bonne conductivité thermique mais présentent l'inconvénient d'un coût très élevé.

Un objectif de l'invention est de fournir une interface d'échange thermique peu coûteuse et facile à réaliser.

L'invention s'applique aussi à la réalisation d'électrodes notamment pour capteur électrochimique ou bioélectrochimique. Une électrode est un système constitué de deux phases en contact, à savoir un conducteur électronique (et hydrophobe) et un conducteur ionique (et hydrophile), dont l'interface est le lieu de transfert de charges entre les constituants des deux phases. FR 2 860 512 décrit un procédé de réalisation d'une cellule -et notamment d'un capteur-électrochimique ou bioélectrochimique, selon lequel : on forme une épaisseur de vermiculite expansée entre deux épaisseurs de graphite expansé, l'épaisseur de vermiculite intégrant éventuellement des réactifs cristallisés ou des enzymes lyophilisées, les épaisseurs de graphite intégrant éventuellement un additif catalytique (métal ou oxyde de métal par exemple) ; on comprime simultanément les trois épaisseurs ainsi formées. La compression permet de consolider et de lier entre elles les trois épaisseurs formées. Chaque épaisseur consolidée de graphite, associée à un contact électrique, forme le conducteur électronique d'une électrode, tandis que l'épaisseur consolidée de vermiculite forme une membrane échangeuse d'ions (conducteur ionique des deux électrodes). Le procédé décrit dans FR 2 860 512 présente les inconvénients susmentionnés des procédés comprenant une étape de consolidation d'un graphite expansé par compression, inconvénients que l'invention permet de pallier. Aussi et surtout, le procédé de FR 2 860 512 ne permet pas de réaliser des électrodes de faible épaisseur (inférieure à 100µm). Lorsque les réactions chimiques ou biochimiques impliquées nécessitent des catalyseurs (enzymes, métaux nobles, etc., intégrés dans la membrane en vermiculite), des quantités relativement importantes de catalyseurs sont donc nécessaires, ce qui grève le coût de revient de cette cellule. En outre, lorsque la cellule est un capteur électrochimique ou bioélectrochimique, le temps de réponse et la sensibilité du capteur sont pénalisés par la distance que doit parcourir l'espèce chimique à doser (présente dans la solution électrolytique ou dans le liquide physiologique analysé) pour parvenir au catalyseur.

L'invention vise à pallier ces inconvénients en proposant un procédé extrêmement simple permettant de fabriquer une électrode de très faible épaisseur, dans laquelle il est cependant possible d'immobiliser des catalyseurs.

L'invention s'applique aussi à la réalisation d'un revêtement sélectif pour convertisseur héliothermique ou autre capteur solaire. Les convertisseurs héliothermiques connus, dont l'objet est de convertir le rayonnement solaire en énergie thermique, comprennent usuellement une plaque d'absorption réalisée en cuivre et dont la face exposée aux rayonnements solaires est traitée, dans une installation industrielle lourde, par anodisation au chrome noir en vue d'une meilleure sélectivité optique (rapport entre l'absorptivité et l'émissivité aux rayonnements thermiques et notamment infrarouges). En raison de sa haute toxicité, le chrome noir est aujourd'hui banni. Des solutions alternatives sont attendues, qui soient respectueuses de l'homme et de l'environnement et soient plus faciles à mettre en oeuvre.

Un objectif de l'invention est d'offrir un procédé extrêmement simple permettant de réaliser un revêtement non toxique, écologique et présentant une sélectivité optique satisfaisante.

L'invention vise en outre à proposer un procédé de fabrication d'un tel solide conducteur présentant néanmoins aussi des propriétés de résistance à la flamme améliorées et permettant son utilisation à titre de barrière anti-feu.

L'invention vise en outre à proposer un procédé de fabrication d'un solide conducteur présentant des propriétés d'imperméabilité améliorée notamment par marouflage de la surface du solide conducteur.

Dans toutes ses applications et dans une version préférée, l'invention vise aussi à proposer un procédé de fabrication n'utilisant aucun produit dangereux ou toxique. Un autre objectif de l'invention est de fournir un solide entièrement recyclable. L'invention vise également à proposer un procédé de fabrication n'utilisant aucun produit organique -et notamment aucun solvant ou liant organique-. Une version de l'invention fournit également un procédé n'utilisant aucun produit synthétique -et notamment aucun produit synthétique polymérique-.

Dans toutes ses applications, l'invention concerne un procédé de fabrication d'un solide conducteur thermique et/ou électrique, dans lequel :
- on prépare au moins une dispersion aqueuse dopée comprenant une poudre de mica et au moins une poudre de dopant, dispersées dans un liquide aqueux non ionique, chaque dopant étant choisi parmi les graphites, à l'exception des graphites expansibles non expansés, le mica représentant au moins 5%, notamment entre 5% et 99%, en poids des matières solides de la dispersion, le ou les dopant(s) représentant 1% à 95% en poids des matières solides de la dispersion, la proportion de chaque dopant étant choisie en fonction des conductivités thermique et électrique recherchées,
- on met en forme chaque dispersion aqueuse dopée, la proportion massique de matières solides dans la dispersion ayant été choisie de façon à obtenir, pour la dispersion aqueuse dopée, une viscosité compatible avec la technique de mise en forme utilisée,
- on laisse chaque dispersion aqueuse dopée se consolider en forme, par évaporation au moins de la phase aqueuse du liquide de dispersion à une température inférieure à 80°C, en particulier à température ambiante.

Il est ainsi possible d'obtenir un solide sans qu'aucune étape de chauffage à température élevée (en vue de cuire un liant ou d'exfolier un composé expansible pour obtenir sa consolidation par compression dans un moule) ni aucune étape de compression ou de laminage n'ait nécessairement à être mise en oeuvre. La consolidation de chaque dispersion aqueuse dopée est obtenue par évaporation du liquide de dispersion (ou du moins de sa phase aqueuse), autrement dit par simple séchage, et ce, quelle que soit l'épaisseur de dispersion mise en forme. A noter que cette évaporation peut être naturelle ou forcée (avec ventilation par exemple). Elle est de préférence obtenue sans chauffage, c'est-à-dire à température ambiante, notamment par séchage à l'air à température ambiante. Mais il n'est pas exclu de chauffer légèrement la dispersion mise en forme ou l'air environnant, en vue d'accélérer l'évaporation. Dans la plupart des applications de l'invention, il est cependant préférable que la dispersion aqueuse dopée conserve une température inférieure à 80°C durant cette étape de consolidation, en vue d'éviter toute ébullition de sa phase aqueuse (une telle ébullition modifiant la structure et l'aspect du solide obtenu).

La consolidation présente en outre l'avantage de s'effectuer sensiblement à volume constant. Les inventeurs attribuent a posteriori ce phénomène exclusivement à la poudre de mica, qui, selon eux, formerait un réseau cohésif au fur et à mesure que le liquide de dispersion s'évapore. Ils ont déterminé qu'une structuration correcte ne pouvait être obtenue qu'à condition, d'une part d'éviter la floculation de la dispersion en utilisant un liquide de dispersion non ionique, et d'autre part d'intégrer dans la dispersion une quantité de poudre de mica supérieure ou égale à 5% en poids de matières solides.

Cette consolidation sans compression, sans laminage ni cuisson autorise la réalisation d'un solide *"in situ",* directement dans le dispositif finalement destiné à l'accueillir. La matière formant le solide étant introduite dans ce dispositif sous la forme d'une dispersion aqueuse, liquide à pâteuse, il est possible de réaliser un solide de forme quelconque.

Aussi et surtout, la consolidation de chaque dispersion aqueuse dopée est obtenue y compris lorsque le dopant qu'elle contient est un graphite expansé. L'invention fournit ainsi pour la première fois un solide à base de graphite expansé dans lequel le graphite expansé n'est ni recomprimé ni associé à un liant organique. Le graphite restant sous forme expansée, le solide obtenu présente une faible masse volumique, ce qui est appréciable dans de nombreuses applications.

L'invention fournit aussi pour la première fois un solide conducteur thermique et/ou électrique à base de mica et d'un dopant, notamment d'un dopant à base de graphite, qui est exempt de tout liant ou composé organique.

Quels que soient le ou les dopants choisis, le procédé selon l'invention est particulièrement simple et économique. A noter que les graphites sont particulièrement adaptés en raison de leur faible coût.

Le solide obtenu selon l'invention est conducteur thermique et/ou électrique selon le ou les dopants utilisés. Ce résultat n'était pas prévisible compte tenu du caractère isolant thermique et électrique du mica. En outre, les solides antérieurs connus comprenant du graphite sous forme expansée non recomprimée (le graphite est dans ce cas associé à un liant organique) sont généralement des isolants thermiques et électriques. Les inventeurs ne pouvaient donc présumer du caractère conducteur du solide obtenu par le procédé selon l'invention.

Selon l'invention, la proportion -en poids de matières solides-de chaque dopant ajouté détermine les conductivités thermique et électrique du solide obtenu. Il est ainsi possible d'ajuster les propriétés dudit solide en fonction de l'application envisagée.

Avantageusement et selon l'invention, on disperse la poudre de mica et la (les) poudre(s) de dopant(s) dans le milieu aqueux non ionique, de façon à former la (les) dispersion(s) aqueuse(s) dopée(s). En particulier, on disperse la poudre de mica ou la (les) poudre(s) de dopant(s) dans le milieu aqueux non ionique, de façon à former une dispersion intermédiaire, puis on ajoute et on mélange la (les) poudre(s) restantes à ladite dispersion intermédiaire pour former la (les) dispersion(s) aqueuse(s) dopée(s). Ainsi la préparation de chaque dispersion aqueuse dopée peut s'effectuer alternativement :
- en mélangeant préalablement la poudre de mica et chaque poudre de dopant, puis en dispersant le mélange pulvérulent obtenu dans le liquide de dispersion,
- en dispersant la poudre de mica ou la poudre de dopant dans le liquide de dispersion de façon à former une dispersion intermédiaire, puis en ajoutant et en mélangeant la poudre restante à la dispersion intermédiaire ; en cas de pluralité de dopants, la dispersion intermédiaire peut être formée à partir d'une poudre ou de plusieurs poudres préalablement mélangées ; si plusieurs poudres restent à ajouter à cette dispersion intermédiaire, celles-ci peuvent être mélangées préalablement à leur introduction dans la dispersion intermédiaire ou introduites successivement dans celle-ci.

Avantageusement et selon l'invention, pour au moins une -et de préférence pour chaque- dispersion aqueuse dopée, on utilise de l'eau déminéralisée et/ou déionisée à titre de liquide de dispersion. Ainsi, de préférence, le procédé n'utilise aucun solvant organique.

Dans une version préférée, chaque dispersion aqueuse dopée est préparée exclusivement à partir d'eau déminéralisée, de poudre de mica et de poudre(s) de dopant. Ainsi, le procédé selon l'invention n'utilise aucun produit toxique ou dangereux pour l'homme ou l'environnement ; il fournit de surcroît un solide entièrement recyclable et, le cas échéant, écologique. En particulier, le procédé selon l'invention ne met en oeuvre aucun liant ou composé organique pour la fabrication d'un solide conducteur thermique et/ou électrique.

Avantageusement et selon l'invention, le procédé présente également au moins l'une ou plusieurs des caractéristiques suivantes :
- chaque mica est choisi parmi les vermiculites -et notamment les vermiculites expansées (sous l'effet d'un choc thermique) et les vermiculites délaminées chimiquement- ;
- pour chaque dispersion aqueuse dopée, au moins un dopant est choisi parmi les graphites naturels et notamment les graphites naturels expansés, les graphites synthétiques. En particulier, on choisit au moins un dopant dans le groupe formé des graphites non expansibles.
- la proportion massique de matières solides dans chaque dispersion aqueuse dopée est comprise entre 5 et 40%. Cette proportion massique de matières solides dans la dispersion en détermine la viscosité ; cette viscosité peut donc être ajustée en fonction de la technique de mise en forme choisie ;
- la proportion massique de mica dans les matières solides de la dispersion aqueuse dopée est comprise entre 5 et 50%, notamment entre 20% et 50%, en particulier proche de 40%.
- chaque poudre de mica utilisée est constituée de particules de dimensions comprises entre 1 et 200µm; pour faciliter la dispersion, elle comprend de préférence au moins 90% de particules inférieures à 90µm, et au moins 50% de particules inférieures à 40µm;
- chaque poudre de dopant utilisée est constituée de particules de dimensions comprises entre 1 et 200µm. Lorsque le dopant est un graphite naturel expansé, le graphite est broyé de façon à ce que la poudre utilisée comprennent de préférence au moins 90% de particules inférieures 60µm, et au moins 50% de particules inférieures à 30µm.

Selon l'invention, diverses techniques de mise en forme peuvent être employées pour mettre en forme chaque dispersion aqueuse dopée. Si plusieurs dispersions aqueuses dopées sont préparées pour fabriquer le solide, celles-ci peuvent être mises en forme selon la même technique ou selon des techniques différentes.

Selon une première technique, la dispersion aqueuse dopée (c'est-à-dire au moins une dispersion du procédé) est mise en forme par application d'au moins une couche de dispersion aqueuse dopée sur un support. Cette application peut être effectuée à l'aide d'un pinceau, d'un rouleau, d'un pulvérisateur... La proportion de matières solides dans la dispersion aqueuse dopée est ajustée de façon à obtenir une viscosité compatible avec l'outil utilisé pour l'application et avec l'épaisseur de couche souhaitée.

Selon une deuxième technique, la dispersion aqueuse dopée (c'est-à-dire au moins une dispersion du procédé) est mise en forme par trempage d'un support dans la dispersion aqueuse dopée. La proportion de matières solides dans la dispersion est dans ce cas ajustée de façon à obtenir une dispersion aqueuse dopée relativement liquide. Plusieurs trempages successifs dans la même dispersion aqueuse dopée peuvent être prévus.

Pour ces deux premières techniques de mise en forme, on peut utiliser un support plan anti-adhérent. Le solide obtenu est alors une feuille que l'on peut détacher du support après consolidation de la (ou des) dispersion(s) aqueuse(s) dopée(s). Pour obtenir une feuille ayant une bonne tenue mécanique, chaque dispersion aqueuse dopée utilisée comprend de préférence au moins 25% de mica en poids de matières solides.

En variante, le solide obtenu peut être un film de revêtement (conducteur) adhérant au support, sous réserve d'utiliser un support n'ayant reçu aucun traitement de finition anti-adhérent susceptible d'empêcher l'adhésion dudit film.

Un tel film de revêtement peut être obtenu à partir d'une seule dispersion aqueuse dopée, avec laquelle on forme une ou éventuellement plusieurs couche(s) sur le support (par application ou par trempage).

En variante, on prépare une pluralité de dispersions aqueuses dopées et l'on forme successivement, par application (première technique) ou par trempage (deuxième technique), plusieurs couches de dispersions aqueuses dopées sur le support. En particulier :
- on prépare au moins une dispersion aqueuse dopée, dite dispersion d'accroche, comprenant une proportion de mica supérieure à 50% -et de préférence supérieure à 70%- en poids de matières solides, et une dispersion aqueuse dopée, dite dispersion de finition, comprenant une proportion de dopant(s) supérieure à 50% -et de préférence supérieure à 70%- en poids de matières solides ;
- on forme successivement plusieurs couches de dispersions aqueuses dopées sur le support, la première couche étant formée avec la dispersion d'accroche, la dernière couche étant formée avec la dispersion de finition.

La couche d'accroche présente une structure très cohésive, qui garantit l'adhérence du film de revêtement au support. La couche de finition confère au film les propriétés souhaitées, non seulement en termes de conductivité thermique et/ou électrique mais aussi en termes d'aspect. Pour améliorer plus encore la pérennité du film de revêtement, une couche intermédiaire peut être formée avec une dispersion aqueuse dopée comprenant 50% de mica en poids de matières solides.

A noter qu'il est possible de former une couche alors que la précédente couche formée n'est pas encore consolidée et/ou sèche ; en variante, on attend qu'une couche formée soit consolidée et/ou sèche avant de former l'éventuelle couche suivante. Par ailleurs, il est possible d'employer des techniques de mise en forme (application au rouleau, application au pinceau..., trempage) différentes d'une couche à l'autre, ou au contraire d'employer la même technique pour toutes les couches.

Le procédé selon l'invention permet de fabriquer des films de revêtement sur des supports de nature et de forme quelconques.

Le support peut être une face d'absorption d'un convertisseur héliothermique (ou autre capteur solaire). Dans ce cas, le dopant ou au moins l'un des dopants est un graphite et de préférence un graphite naturel expansé. La conductivité thermique et la sélectivité optique du film de revêtement obtenu dépendent de la proportion de graphite en poids de matières solides. La sélectivité optique du film peut être proche de 2 (qui est la sélectivité optique moyenne d'un graphite naturel). En outre, le film de revêtement obtenu est dépourvu de produit toxique ou dangereux et est entièrement recyclable. L'énergie thermique absorbée par le film de revêtement fabriqué devant être transmise au support (face d'absorption) puis à un circuit de fluide (eau ou fluide calorifique), il est préférable de ne pas prévoir de couche d'accroche telle que précédemment définie, dont la conductivité thermique est moins bonne. Cependant, cette hypothèse n'est pas exclue (les performances du convertisseur héliothermique restant acceptables).

Le support peut être un contact électrique. Le film de revêtement obtenu constitue une électrode, dite électrode mince, qui peut avantageusement être utilisée dans un capteur électrochimique ou bioélectrochimique (capteur à oxygène, cellule de mesure du taux de glucose dans le sang, etc.). Le mica contenu dans le film forme un squelette hydrophile échangeur d'ions, tandis que le dopant assure le transport des électrons entre ce squelette et le contact électrique. Le mica et le dopant étant sous la forme de particules de petites dimensions, mélangées les unes aux autres, la surface d'échange entre le mica -conducteur ionique de l'électrode- et le dopant - conducteur électronique de l'électrode- est importante, ce qui favorise les échanges. En outre, il est possible de fabriquer une électrode mince très fine, et notamment d'épaisseur inférieure à 100µm, dans laquelle la solution électrolytique (dans le cas d'un capteur électrochimique) ou le liquide physiologique (dans le cas d'un capteur bioélectrochimique) diffuse facilement, d'autant plus facilement que le film n'a subi aucune compression. Un capteur utilisant une telle électrode offre ainsi une réponse très rapide et une grande sensibilité. En outre, compte tenu de son faible volume, l'électrode mince selon l'invention nécessite, pour son fonctionnement, une quantité de catalyseur (enzymes, métaux nobles...) très inférieure à celle des électrodes antérieures connues. Elle est par conséquent bien moins chère que ces dernières. A noter, afin de favoriser les échanges électroniques entre le film de revêtement fabriqué (électrode mince) et le support (contact), qu'il est préférable de ne pas prévoir de couche d'accroche telle que précédemment définie, dont la conductivité électrique est moins bonne. Cependant, cette hypothèse n'est pas exclue (les performances de l'électrode obtenue restant acceptables).

A noter également que le contact servant de support peut être massif (l'électrode réalise dans ce cas une sorte d'enrobage du contact, qui peut être mis en forme par trempage par exemple) ou mince (contact réalisé par impression-*"screen printing*"*-* d'une fine couche d'or ou autre métal conducteur sur un support quelconque, et par exemple sur une feuille de polyester ou de polyéthylène téréphtalate). Pour réaliser une électrode mince, il est également possible d'utiliser un support quelconque et notamment non conducteur (tel qu'une feuille de polyéthylène téréphtalate), puis de mettre en contact électrique le film de revêtement réalisé selon l'invention sur ce support avec un contact de type pince crocodile par exemple.

Le support peut en variante être un objet d'art, et notamment un objet purement artistique telle qu'une sculpture, ou un équipement mobilier dit équipement d'art, tel qu'un radiateur d'art (radiateur pour le chauffage d'une pièce d'un bâtiment, mais qui possède une forme esthétique et s'affiche tel un tableau ou une sculpture...). L'objet d'art servant de support peut être en un matériau quelconque, de préférence légèrement poreux : bois, plâtre, résine, pierre naturelle ou reconstituée... Le revêtement obtenu forme une patine non seulement conductrice (et notamment conductrice de la chaleur pour ce qui concerne le radiateur d'art) mais aussi et surtout esthétique, dont la teinte et la nuance dépendent de la nature et de la quantité de dopant(s) choisi(s). En outre, lorsque le dopant est un graphite expansé, la patine, mate en l'absence de traitement supplémentaire, devient brillante lorsqu'elle est frottée ; l'objet d'art revêtu selon l'invention présente alors un aspect lustré. Le graphite utilisé à titre de dopant confère à l'objet d'art l'aspect du bronze. Pour obtenir une teinte très foncée, il convient d'utiliser une dispersion aqueuse dopée comprenant plus de 70% de graphite expansé en poids de matières solides ; il est dans ce cas préférable de former plusieurs couches de dispersion sur l'objet, dont une couche d'accroche telle que précédemment définie.

Quel que soit le support utilisé, le film de revêtement ou la feuille obtenu(e) selon l'invention est perméable aux liquides en l'absence de traitement supplémentaire ; il(elle) devient beaucoup moins perméable aux liquides lorsqu'il(elle) est frotté(e), par exemple au doigt ou éventuellement à l'aide d'un chiffon ou d'un quelconque outil de polissage. Cette propriété inattendue permet de réaliser, y compris à partir d'une unique dispersion et en une seule application, un film de revêtement ou une feuille présentant des zones perméables (zones non frottées) et des zones beaucoup moins perméables (zones frottées). Ainsi, dans le procédé selon l'invention, une fois consolidée, la couche de dispersion aqueuse dopée formée (il peut s'agir de l'unique couche formée, ou de la couche de finition en cas de pluralité de couches) est avantageusement entièrement (c'est-à-dire sur toute sa surface) ou partiellement (sur certaines zones seulement) frottée.

Selon une troisième technique, l'étape de mise en forme de la dispersion aqueuse dopée comprend le dépôt d'une couche de dispersion aqueuse dopée sur un premier support et l'application d'un deuxième support sur ladite couche. Ce dépôt peut être effectué à l'aide d'une seringue.

Avantageusement et selon l'invention, le premier support est une face d'un élément émetteur de chaleur et le deuxième support est une face d'un élément de récupération et/ou d'évacuation de chaleur. En particulier, l'élément émetteur de chaleur et l'élément de récupération et/ou d'évacuation de chaleur sont des organes d'un échangeur thermique. Dans une autre application; l'élément émetteur de chaleur est un microprocesseur -ou plus généralement un composant électronique-, et l'élément de récupération et/ou d'évacuation de chaleur est un élément radiateur pour microprocesseur -ou plus généralement un élément radiateur pour composant électronique-...

Le solide obtenu constitue dans ce cas une interface d'échange thermique, efficace, peu coûteuse et simple à réaliser. La dispersion aqueuse dopée étant appliquée à l'état visqueux, elle épouse parfaitement les faces des éléments entre lesquelles elle est agencée. La surface d'échange thermique entre ces éléments et l'interface solide obtenue est donc maximale. En outre, il s'avère que cette interface adhère aux faces des éléments.

Avec cette troisième technique de mise en forme, le solide obtenu selon l'invention peut également être une soudure électrique, qui présente l'avantage d'être réalisée à froid, ou une couche d'adhésif conducteur thermique, de surcroît réfractaire, qui présente l'avantage de ne contenir aucun produit toxique, dangereux ou non recyclable.

Selon une quatrième technique, la dispersion aqueuse dopée (c'est-à-dire au moins une dispersion du procédé) est mise en forme par moulage. Le moulage peut être effectué à l'aide d'un moule d'usine ou *"in situ",* directement dans le dispositif destiné finalement à accueillir le solide, une partie du dispositif faisant alors office de moule.

Cette quatrième technique permet par exemple de fabriquer une électrode, dite électrode massive (par opposition à l'électrode mince précédemment définie), un réacteur chimique, un objet d'art... A noter que l'expression *"réacteur chimique"* désigne le lieu d'une réaction, dite réaction chimique, qui peut être purement chimique ou électrochimique ou biochimique ou bioélectrochimique.

Avantageusement et selon l'invention, dans le cadre de la fabrication d'un réacteur chimique ou d'une électrode massive ou mince, la dispersion aqueuse dopée préparée peut comprendre au moins un agent actif choisi parmi : un réactif d'une réaction chimique et/ou d'une réaction d'oxydoréduction, un catalyseur d'une réaction chimique et/ou d'une réaction d'oxydoréduction, un agent adsorbant d'une réaction physique d'adsorption.

Le catalyseur est par exemple une enzyme. Les enzymes sont généralement détruites sous l'effet de la chaleur, lorsque la température dépasse 40°C. Parce qu'il peut être mis en oeuvre sans étape de chauffage, le procédé selon l'invention permet d'intégrer des enzymes dans un réacteur ou une électrode (massive ou mince) lors de la fabrication du réacteur ou de l'électrode. En outre, les enzymes, fixées par le mica (hydrophile), se retrouvent immobilisées au sein du réacteur ou de l'électrode dans une matrice tridimensionnelle hydrophile, ce qui présente des avantages par rapport à tous les dispositifs -et notamment les biocapteurs- antérieurs connus :
- contrairement aux biocapteurs antérieurs dans lesquels les enzymes sont confinées dans une matrice polymérique hydrophobe (et donc très différente de leur milieu naturel), la matrice de mica hydrophile selon l'invention préserve les enzymes et favorise la diffusion de l'espèce chimique à doser. Un biocapteur réalisé à partir d'une électrode ou d'un réacteur selon l'invention est donc plus pérenne et plus fiable que les biocapteurs connus à matrice polymérique ; il offre de plus un temps de réponse plus faible ;
- contrairement aux biocapteurs antérieurs dans lesquels les enzymes sont adsorbées à la surface d'une électrode et se dégradent rapidement, la matrice de mica tridimensionnelle protège les enzymes, garantissant ainsi la pérennité et la fiabilité du biocapteur obtenu ; en outre, le biocapteur selon l'invention présente une sensibilité accrue, dans la mesure où une quantité plus importante d'enzymes peut y être fixée (seule une très faible quantité d'enzymes peut être adsorbée dans les biocapteurs antérieurs) ;
- contrairement aux biocapteurs dans lesquels les enzymes sont emprisonnées par une membrane, dont la réalisation est très délicate, la réalisation d'un biocapteur selon l'invention est extrêmement simple et peut aisément être industrialisée.

En outre, la quantité d'agent(s) actif(s) présente dans le réacteur chimique ou l'électrode (massive ou mince) fabriqué selon l'invention correspond à celle introduite dans la dispersion aqueuse ; elle peut donc être contrôlée avec précision (contrairement aux procédés antérieurs connus qui prévoient d'imbiber un réacteur en le trempant dans une solution d'agent actif, ou encore d'adsorber des enzymes à la surface d'une électrode).

L'invention concerne également un procédé de fabrication d'un solide conducteur thermique et/ou électrique caractérisé en combinaison par tout ou partie des caractéristiques mentionnées ci-dessus et ci-après.

D'autres buts, caractéristiques et avantages de l'invention apparaîtront à la lecture de la description suivante qui propose quelques exemples, non limitatifs, de réalisation de l'invention.

### Exemple 1

On prépare une dispersion aqueuse dopée à partir de 72,08 g d'une dispersion de vermiculite à 7,5%, auxquels on mélange 12,70g de graphite naturel expansé broyé. La dispersion aqueuse dopée présente les caractéristiques suivantes :
- masse d'eau déminéralisée : 66,67g
- masse de vermiculite : 5,41g
- masse de graphite naturel expansé broyé : 12,70g
- proportion de vermiculite en poids de matières solides : 29,87%
- proportion de graphite en poids de matières solides : 70,13%
- proportion massique de matières solides dans la dispersion aqueuse dopée : 21,36%
- granulométrie de la poudre de vermiculite : toutes les particules sont comprises entre 3 et 180µm. 15% des particules sont inférieures à 10µm, 50% des particules sont inférieures à 30µm, 70% des particules sont inférieures 50µm, 90% des particules sont inférieures à 80µm,
- granulométrie de la poudre de graphite : 90% de particules inférieures à 45µm, dont 50% de particules inférieures à 15µm. aucune particule supérieure à 200µm.

Cette dispersion aqueuse dopée est assez visqueuse (elle ne coule quasiment pas) sans être totalement pâteuse.

On réalise plusieurs échantillons de solide à partir de cette dispersion. Chaque échantillon est réalisé en versant dans un moule une couche d'un centimètre de dispersion, que l'on laisse sécher à l'air libre et à température ambiante.

Les échantillons obtenus sont considérés comme étant secs et sont testés dès qu'ils ne sont plus malléables. Leur conductivité thermique (selon la direction de l'épaisseur de l'échantillon) est mesurée à température ambiante, à l'aide d'un conductimètre à disque chaud ("hot disk thermal instrument").

Les échantillons présentent une conductivité thermique λ moyenne de 5 W.m⁻¹.k⁻¹.

### Exemple 2

On prépare une dispersion aqueuse dopée selon l'exemple 1. On forme une couche de dispersion aqueuse dopée entre une face -dite face d'échange- d'un microprocesseur et une face -également dite face d'échange- d'un élément radiateur. Pour ce faire, on dépose la dispersion aqueuse dopée sur la face d'échange du microprocesseur à l'aide d'une seringue, en une quantité suffisante pour que, une fois l'élément radiateur mis en place, la dispersion recouvre ladite face d'échange du microprocesseur. On place l'élément radiateur sur la dispersion, en regard du microprocesseur, en appliquant la face d'échange de l'élément radiateur contre la dispersion (visqueuse) et en écrasant cette dernière. Selon une première méthode, on laisse sécher la dispersion à température ambiante jusqu'à obtenir sa consolidation et former ainsi une interface d'échange thermique. Alternativement, selon une deuxième méthode, on met en route le microprocesseur afin d'accélérer le séchage, d'obtenir une consolidation dite "in situ" et de disposer d'une interface thermique dont le temps de rétention est nul, le circuit électronique réalisé étant ainsi immédiatement pleinement opérationnel.

Les inventeurs ont pu constater, en décollant ultérieurement l'élément radiateur et le microprocesseur de l'interface d'échange thermique, que cette dernière adhère fortement à leur face d'échange respective, et ce, sur des surfaces de contact maximales : lorsqu'elle est encore à l'état visqueux, la dispersion aqueuse dopée s'infiltre dans les aspérités des faces d'échange du microprocesseur et de l'élément radiateur ; en séchant, elle adhère auxdites faces d'échange ; l'interface solide obtenue épouse de façon très satisfaisante ces faces, en comblant les micro-espaces dus aux imperfections des surfaces en regard, ce qui améliore les transferts de chaleur.

### Exemple 3

On prépare une dispersion aqueuse dopée selon l'exemple 1. On applique la dispersion aqueuse dopée sur un support plan anti-adhérent au moyen d'un pinceau de façon à former une couche d'environ 1 mm d'épaisseur. On laisse sécher la dispersion à température ambiante jusqu'à sa consolidation. On obtient une feuille de 90 à 100µm d'épaisseur, que l'on désolidarise du support. On mesure la conductivité électrique de la feuille (selon une direction parallèle au plan de la feuille) en fonction de la température.

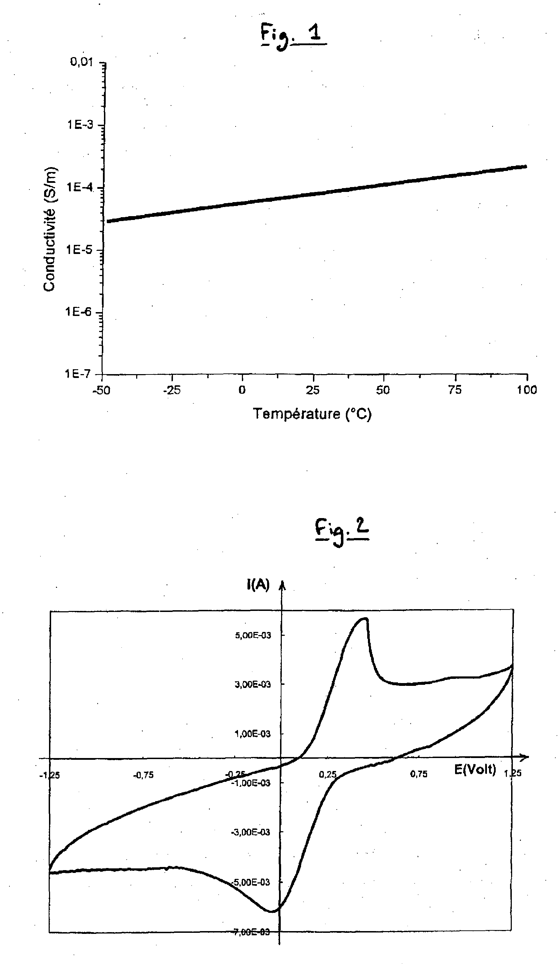

Les résultats sont consignés dans le graphique représenté sur la figure 1. La conductivité électrique moyenne mesurée est de 1.E⁻⁴ S.m⁻¹. Au vu de ces résultats, la feuille réalisée selon l'invention peut être qualifiée de "semi-métal" ou "semi-conducteur".

### Exemple 4

Une bandelette découpée dans la feuille fabriquée selon l'exemple 3 est testée à titre d'électrode mince, par voltamétrie cyclique dans une solution électrolytique de ferri-ferro cyanure et avec une électrode auxiliaire de platine et une électrode de référence. Un balayage du potentiel aller-retour est effectué à vitesse constante de 50mV/s entre une limite anodique de 1,25V et une limite cathodique de -1,25V. Le courant est mesuré.

Les résultats sont reportés dans le graphique représenté sur la figure 2. La présence de pics d'intensité confirme l'échange d'électrons entre le circuit électronique de mesure et la solution ionique, via l'électrode mince. Par ailleurs, l'électrode présente une composante résistive compatible avec les applications envisagées de capteur chimique ou bioélectrochimique.

Ces résultats sont d'autant plus encourageants que la liaison électrique entre la bandelette (électrode mince) selon l'invention et le circuit de mesure a été réalisée au moyen d'une simple pince conductrice (de type pince crocodile). Cette liaison est par conséquent ponctuelle et non optimisée. Des échanges électroniques plus importants devraient être enregistrés en diminuant la résistance de contact entre l'électrode et le contact électrique (en l'espèce celui du circuit de mesure), par exemple en appliquant directement la dispersion aqueuse dopée sur une face, dite face d'échange, dudit contact de façon à former une électrode mince adhérant audit contact sur toute sa face d'échange.

### Exemple 5

On prépare une dispersion aqueuse selon l'exemple 1 avec laquelle on forme, sur l'une des faces principales d'une pièce de mousse de carbone utilisée dans l'industrie du bâtiment, une couche anti-feu de solide conducteur selon l'invention d'une épaisseur de l'ordre de 320 µm. On expose à la flamme d'un chalumeau, la face de la pièce de mousse de carbone recouverte de la couche de solide conducteur et on mesure, sur la face opposée de la pièce de mousse de carbone, la variation de la température. On exprime le gain de protection engendré par la couche anti-feu comme le rapport de la durée d'exposition à la flamme d'un échantillon traité *versus* d'un échantillon contrôle non traité nécessaire pour conduire à la perforation de l'échantillon.

Le gain de protection, apporté par la protection anti-feu, pour une mousse de carbone de masse volumique de 2 kg/m³ est de 3,6. La perforation de l'échantillon non traité intervient après 315 s d'exposition à la flamme, alors que la perforation de l'échantillon anti-feu intervient après 1160 s.

Le gain de protection, apporté par la protection anti-feu, pour une mousse de carbone de masse volumique de 30 kg/m³ est de l'ordre de 2. La perforation de l'échantillon non traité intervient après 8415 s, alors que la perforation de l'échantillon anti-feu intervient après 2 h et 20 min.

### Exemple 6

On réalise des essais anti-feu similaires aux essais décrits à l'exemple 5 avec des pièces de Placoplatre^{®} cartonnées (BA13) de 13 mm d'épaisseur utilisée dans l'industrie du bâtiment.

Le gain de protection, apporté par la protection anti-feu, pour une plaque de Placoplatre^{®} BA13 est de l'ordre de 5,5. La perforation de la plaque non traitée intervient après 13 min, alors que la perforation de la plaque anti-feu intervient après 1 h et 11 min.

## Revendications

1. Procédé de fabrication d'un solide conducteur thermique et/ou électrique, dans lequel:
- on prépare au moins une dispersion aqueuse dopée comprenant une poudre de mica et au moins une poudre de dopant, dispersées dans un liquide aqueux non ionique, chaque dopant étant choisi parmi les graphites, à l'exception des graphites expansibles non expansés, le mica représentant au moins 5% en poids des matières solides de la dispersion, le ou les dopant(s) représentant 1% à 95% en poids des matières solides de la dispersion, la proportion de chaque dopant étant choisie en fonction des conductivités thermique et électrique recherchées,
- on met en forme chaque dispersion aqueuse dopée, la proportion massique de matières solides dans la dispersion ayant été choisie de façon à obtenir, pour la dispersion aqueuse dopée, une viscosité compatible avec la technique de mise en forme utilisée,
- on laisse la dispersion aqueuse dopée se consolider en forme, par évaporation au moins de la phase aqueuse du liquide de dispersion à une température inférieure à 80°C, en particulier à température ambiante.

2. Procédé selon la revendication 1, **caractérisé en ce qu'**on disperse la poudre de mica et la (les) poudre(s) de dopant(s) dans le milieu aqueux non ionique, de façon à former la (les) dispersion(s) aqueuse(s) dopée(s).

3. Procédé selon l'une des revendications 1 et 2, **caractérisé en ce qu'**on disperse la poudre de mica ou la (les) poudre(s) de dopant(s) dans le milieu aqueux non ionique, de façon à former une dispersion intermédiaire, puis on ajoute et on mélange la (les) poudre(s) restantes à ladite dispersion intermédiaire pour former la (les) dispersion(s) aqueuse(s) dopée(s).

4. Procédé selon l'une des revendications 1 à 3, **caractérisé en ce que**, pour chaque dispersion aqueuse dopée, on utilise de l'eau déminéralisée et/ou déionisée à titre de liquide de dispersion.

5. Procédé selon la revendication 2, **caractérisé en ce que** chaque dispersion aqueuse dopée est préparée exclusivement à partir d'eau déminéralisée et/ou déionisée, de poudre de mica et de poudre(s) de dopant.

6. Procédé selon l'une des revendications 1 à 5, **caractérisé en ce que**, pour chaque dispersion aqueuse dopée, au moins un dopant est choisi parmi les graphites naturels expansés et les graphites synthétiques.

7. Procédé selon l'une des revendications 1 à 6, **caractérisé en ce que**, pour chaque dispersion aqueuse dopée, on choisit au moins un dopant dans le groupe formé des graphites non expansibles.

8. Procédé selon l'une des revendications 1 à 7, **caractérisé en ce que** chaque poudre de mica utilisée est constituée de particules de dimensions comprises entre 1 et 200 µm.

9. Procédé selon l'une des revendications 1 à 8, **caractérisé en ce que** chaque poudre de dopant utilisée est constituée de particules de dimensions comprises entre 1 et 200 µm.

10. Procédé selon l'une des revendications 1 à 9, **caractérisé en ce qu'**au moins une dispersion aqueuse dopée est mise en forme par application d'au moins une couche de dispersion aqueuse dopée sur un support.

11. Procédé selon l'une des revendications 1 à 9, **caractérisé en ce qu'**au moins une dispersion aqueuse dopée est mise en forme par trempage d'un support dans la dispersion aqueuse dopée.

12. Procédé selon l'une des revendications 10 ou 11, **caractérisé en ce que** le solide obtenu est un film de revêtement adhérant au support.

13. Procédé selon l'une des revendications 1 à 12, **caractérisé en ce que** l'étape de mise en forme comprend le dépôt d'une couche de dispersion aqueuse dopée sur un premier support et l'application d'un deuxième support sur ladite couche.

14. Procédé selon l'une des revendications 1 à 13, **caractérisé en ce qu'**au moins une dispersion aqueuse dopée est mise en forme par moulage.

15. Procédé selon la revendication 14, **caractérisé en ce que** le solide obtenu constitue une électrode, dite électrode massive, ou un réacteur chimique.

## Patentansprüche

1. Verfahren zur Herstellung eines wärme- und/oder stromleitenden Feststoffs, wobei
- mindestens eine dotierte wässrige Dispersion zubereitet wird, umfassend ein Glimmerpulver und mindestens ein Dotiermittelpulver, die in einer nicht ionischen wässrigen Flüssigkeit dispergiert sind, wobei jedes Dotiermittel ausgewählt ist aus Graphiten, mit Ausnahme der nicht expandierten expandierbaren Graphite, wobei der Glimmer mindestens 5 Gew% der Feststoffe der Dispersion darstellt, wobei der oder die Dotiermittel 1 Gew% bis 95 Gew% der Feststoffe der Dispersion darstellen, wobei die Proportion jedes Dotiermittels je nach den gewünschten Wärme- und Stromleitfähigkeiten ausgewählt wird.
- jede dotierte wässrige Dispersion in Form gebracht wird, wobei die Massenproportion der Feststoffe in der Dispersion derart gewählt wurde, um, für die dotierte wässrige Dispersion, eine Viskosität zu erhalten, die mit der verwendeten Technik der Formgebung kompatibel ist,
- die Form der dotierten wässrigen Dispersion, durch die Verdampfung mindestens der wässrigen Phase der Dispersionsflüssigkeit bei einer Temperatur von weniger als 80 °C, insbesondere bei Raumtemperatur, sich verfestigen gelassen wird.

2. Verfahren nach Anspruch 1, **dadurch gekennzeichnet, dass** das Glimmerpulver und das/die Dotiermittelpulver in dem nicht ionischen wässrigen Medium dispergiert werden, um die dotierte(n) wässrige(n) Dispersion(en) zu bilden.

3. Verfahren nach einem der Ansprüche 1 und 2, **dadurch gekennzeichnet, dass** das Glimmerpulver und das/die Pulver aus Dotiermittel(n) in dem nicht ionischen wässrigen Medium dispergiert werden, um eine Zwischendispersion zu bilden, dann das/die restliche(n) Pulver der Zwischendispersion hinzugefügt und gemischt werden, um die dotierte(n) wässrige(n) Dispersion(en) zu bilden.

4. Verfahren nach einem der Ansprüche 1 bis 3, **dadurch gekennzeichnet, dass** für jede dotierte wässrige Dispersion entmineralisiertes und/oder entionisiertes Wasser als Dispersionsflüssigkeit verwendet wird.

5. Verfahren nach Anspruch 2, **dadurch gekennzeichnet, dass** jede dotierte wässrige Dispersion ausschließlich auf der Grundlage von entmineralisiertem und/oder entionisiertem Wasser aus Glimmerpulver und aus Dotiermittelpulver(n) zubereitet wird.

6. Verfahren nach einem der Ansprüche 1 bis 5, **dadurch gekennzeichnet, dass** für jede dotierte wässrige Dispersion mindestens ein Dotiermittel aus expandierten natürlichen Graphiten und synthetischen Graphiten ausgewählt wird.

7. Verfahren nach einem der Ansprüche 1 bis 6, **dadurch gekennzeichnet, dass** für jede dotierte wässrige Dispersion mindestens ein Dotiermittel aus der Gruppe, gebildet aus nicht expandierbaren Graphiten, auswählt wird.

8. Verfahren nach einem der Ansprüche 1 bis 7, **dadurch gekennzeichnet, dass** jedes verwendete Glimmerpulver aus Partikeln mit Abmessungen zwischen 1 und 200 µm besteht.

9. Verfahren nach einem der Ansprüche 1 bis 8, **dadurch gekennzeichnet, dass** jedes verwendete Dotierpulver aus Partikeln mit Abmessungen zwischen 1 und 200 µm besteht.

10. Verfahren nach einem der Ansprüche 1 bis 9, **dadurch gekennzeichnet, dass** mindestens eine dotierte wässrige Dispersion durch die Aufbringung von mindestens einer Schicht aus dotierter wässriger Dispersion auf einen Träger in Form gebracht wird.

11. Verfahren nach einem der Ansprüche 1 bis 9, **dadurch gekennzeichnet, dass** mindestens eine dotierte wässrige Dispersion durch Eintauchen eines Trägers in die dotierte wässrige Dispersion in Form gebracht wird.

12. Verfahren nach einem der Ansprüche 10 oder 11, **dadurch gekennzeichnet, dass** der erhaltene Feststoff ein Beschichtungsfilm ist, der auf dem Träger haftet.

13. Verfahren nach einem der Ansprüche 1 bis 12, **dadurch gekennzeichnet, dass** der Schritt des Formgebens das Ablegen einer Schicht aus dotierter wässriger Dispersion auf einem ersten Träger und das Aufbringen eines zweiten Trägers auf der Schicht umfasst:

14. Verfahren nach einem der Ansprüche 1 bis 13, **dadurch gekennzeichnet, dass** mindestens eine dotierte wässrige Dispersion durch Abformung in Form gebracht wird.

15. Verfahren nach Anspruch 14, **dadurch gekennzeichnet, dass** der erhaltene Feststoff eine Elektrode darstellt, bezeichnet als massive Elektrode, oder einen chemischen Reaktor.

## Claims

1. Process for manufacturing a thermally and/or electrically conducting solid, **characterised in that**:
- there is prepared at least one doped aqueous dispersion comprising a mica powder and at least one dopant powder, which powders are dispersed in a non-ionic aqueous liquid, each dopant being chosen from the graphites, with the exception of the unexpanded expandable graphites, the mica representing at least 5 wt.% of the solid matter of the dispersion, the dopant(s) representing from 1 wt.% to 95 wt.% of the solid matter of the dispersion, the proportion of each dopant being chosen in dependence on the desired thermal and electrical conductivities,
- each doped aqueous dispersion is shaped, the proportion by mass of solid matter in the dispersion having been chosen so as to obtain, for the doped aqueous dispersion, a viscosity compatible with the shaping technique used,
- the doped aqueous dispersion is allowed to consolidate in terms of its shape, by evaporation at least of the aqueous phase of the dispersion liquid at a temperature below 80°C, in particular at ambient temperature.

2. Process according to claim 1, **characterised in that** the mica powder and the dopant powder(s) are dispersed in the non-ionic aqueous medium so as to form the doped aqueous dispersion(s).

3. Process according to either claim 1 or claim 2, **characterised in that** the mica powder or the dopant powder(s) is/are dispersed in the non-ionic aqueous medium so as to form an intermediate dispersion, and then the remaining powder(s) is/are added to and mixed with said intermediate dispersion to form the doped aqueous dispersion(s).

4. Process according to any one of claims 1 to 3, **characterised in that**, for each doped aqueous dispersion, demineralised and/or deionised water is used as the dispersion liquid.

5. Process according to claim 2, **characterised in that** each doped aqueous dispersion is prepared solely from demineralised and/or deionised water, mica powder and dopant powder(s).

6. Process according to any one of claims 1 to 5, **characterised in that**, for each doped aqueous dispersion, at least one dopant is chosen from the expanded natural graphites and the synthetic graphites.

7. Process according to any one of claims 1 to 6, **characterised in that**, for each doped aqueous dispersion, at least one dopant is chosen from the group formed of the non-expandable graphites.

8. Process according to any one of claims 1 to 7, **characterised in that** each mica powder used is composed of particles having sizes from 1 to 200 µm.

9. Process according to any one of claims 1 to 8, **characterised in that** each dopant powder used is composed of particles having sizes from 1 to 200 µm.

10. Process according to any one of claims 1 to 9, **characterised in that** at least one doped aqueous dispersion is shaped by applying at least one layer of doped aqueous dispersion to a substrate.

11. Process according to any one of claims 1 to 9, **characterised in that** at least one doped aqueous dispersion is shaped by immersing a substrate in the doped aqueous dispersion.

12. Process according to either claim 10 or claim 11, **characterised in that** the solid obtained is a coating film adhering to the substrate.

13. Process according to any one of claims 1 to 12, **characterised in that** the shaping step comprises depositing a layer of doped aqueous dispersion on a first substrate and applying a second substrate to said layer.

14. Process according to any one of claims 1 to 13, **characterised in that** at least one doped aqueous dispersion is shaped by moulding.

15. Process according to claim 14, **characterised in that** the solid obtained constitutes an electrode, called a solid electrode, or a chemical reactor.
